# EUROPEAN PATENT APPLICATION

(11) **EP 4 835 566 A1**
(43) Date of publication of application: **04.11.2026**
(21) Application number: 24912822.4
(22) Date of filing: 24.12.2024
(51) Int. Cl.: G03F 1/24, G03F 1/48

(54) **REFLECTIVE PHOTOMASK**

(30) Priority: 28.12.2023 JP 2023223016
(71) Applicant: Tekscend Photomask Corp., Tokyo 105-7133 (JP)
(72) Inventor: NAKANO, Hideaki, Tokyo 105-7133 (JP); MIYAWAKI, Daisuke, Tokyo 105-7133 (JP)
(74) Representative: TBK
(86) International application number: PCT/JP2024/045710
(87) International publication number: WO 2025/142935

(57) **Abstract**

An object of the present invention is to provide a reflective photomask that can reduce deterioration in transferability due to a phase difference in a reflective portion and improve adhesion (interlayer adhesion) between a capping layer and a protective layer while having excellent hydrogen radical resistance. A reflective mask (10) according to the present embodiment includes a substrate (1), a multilayer reflective film (2), a capping layer (3), an absorber (4), and a protective layer (5) formed on the capping layer (3), on the absorber (4), and on a sidewall of the absorber (4). An extinction coefficient k of the absorber (4) with respect to EUV light is 0.04 or more, the capping layer (3) and the protective layer (5) are formed of the same material, a reflectivity of a reflective portion, which is a region where the absorber (4) is not formed on the capping layer (3), with respect to the EUV light is 50% or more, a total film thickness of the capping layer (3) and the protective layer (5) is 3 nm or more, and the capping layer (3) and the protective layer (5) have resistance to hydrogen radicals.

## Description

### TECHNICAL FIELD

The present invention relates to a reflective photomask used in production of a semiconductor device and the like.

### BACKGROUND ART

In a production process of a semiconductor device, a demand for miniaturization by photolithography technology has been increasing with miniaturization of the semiconductor device. In photolithography, a minimum resolution dimension of a transfer pattern greatly depends on a wavelength of an exposure light source, and a shorter wavelength enables a smaller minimum resolution dimension. Therefore, the exposure light source has been shifting from conventional ArF excimer laser light having a wavelength of 193 nm to light in an extreme ultraviolet (EUV) region having a wavelength of 13.5 nm.

Since the light in the EUV region is highly absorbed by most materials, a reflective photomask is used as a photomask for EUV exposure (EUV mask) (see, for example, Patent Literature 1). Patent Literature 1 discloses an EUV photomask obtained by forming a reflective layer made of a multilayer film in which a molybdenum (Mo) layer and a silicon (Si) layer are alternately deposited on a glass substrate, forming a light absorption layer containing tantalum (Ta) as a main component thereon, and forming a pattern on this light absorption layer.

In EUV lithography, as described above, a refractive optical system using light transmission cannot be used, and thus an optical system member of an exposure apparatus is also not a lens but a reflective type member (mirror). This causes a problem that incident light on a reflective photomask (EUV mask) and reflected light from the EUV mask cannot be designed coaxially. EUV lithography generally employs a technique of allowing EUV light to be incident with an optical axis tilted by 6 degrees from a direction perpendicular to the EUV mask, and guiding reflected light reflected at an angle of -6 degrees to a semiconductor substrate.

In this way, in the EUV lithography, the optical axis is tilted through the mirror, and this may cause a problem called a "shadowing effect" in which the EUV light incident on the EUV mask forms a shadow of a mask pattern (patterned light absorption layer) of the EUV mask.

In a current EUV mask blank, a film having a film thickness of 60 nm to 90 nm and containing tantalum (Ta) as a main component is used as a light absorption layer. When pattern transfer exposure is performed using an EUV mask produced using this mask blank, a contrast might be reduced at an edge portion that is a shadow of a mask pattern depending on a relationship between an incident direction of EUV light and an orientation of the mask pattern. Consequently, problems may occur, such as an increase in line edge roughness of a transfer pattern on a semiconductor substrate and an inability to form a line width at a target dimension, and these may lead to deterioration in transfer performance.

Therefore, a reflective photomask blanks have been studied in which a light absorption layer is changed from tantalum (Ta) to a material having high absorptivity (extinction coefficient) with respect to EUV light, or in which a material having high absorptivity is added to tantalum (Ta). For example, Patent Literature 1 discloses a reflective photomask blank in which a light absorption layer is made of a material containing 50 atomic% (at%) or more of Ta as a main component and further containing at least one element selected from Te, Sb, Pt, I, Bi, Ir, Os, W, Re, Sn, In, Po, Fe, Au, Hg, Ga, and Al.

A capping film is provided on a reflective layer formed of a multilayer film in order to protect the multilayer film. As disclosed in Patent Literature 2, a film such as Ru, which is almost transparent to EUV light, is generally used as the capping film so as not to reduce an EUV reflectivity. With such a configuration, although the reflective layer is protected at the time of pattern formation, Ru in the capping layer is damaged, and since the film is formed to be thin, often only a film of 1 nm to 2 nm remains. When a photomask is used in this state, an apparatus may be contaminated due to peeling of the capping film or the reflective layer may be damaged due to exposure of the reflective layer.

Further, it is known that a mirror is contaminated with carbon and/or a by-products such as generated by EUV irradiation. Accumulation of contaminants on the mirror reduces a reflectivity of a mirror surface and reduces throughput of a lithography apparatus. To solve this problem, Patent Literature 3 discloses a method for removing contaminants from a mirror by generating hydrogen radicals in an apparatus and allowing the hydrogen radicals to react with the contaminants. As described above, a material used for a reflective photomask blank and a reflective photomask is required to have high resistance to hydrogen radicals.

However, among materials having high absorptivity to EUV light, some materials have low hydrogen radical resistance, and a reflective mask formed of a material having low hydrogen radical resistance has a problem in that the reflective mask cannot withstand long-term use.

In order to protect an absorber (light absorption layer) and a capping layer, it is conceivable that a method of covering a processed mask pattern with a covering film is effective as in Patent Literature 4.

However, in a configuration in which the mask pattern is covered with the covering film, when the capping layer and a protective layer in a reflective portion are formed of different materials, there is a possibility that transferability is adversely affected by a phase difference. In addition, since there is an interface between the materials, hydrogen is accumulated at the interface, which may cause peeling. Further, since a protective film made of a different material is deposited on the damaged film (capping layer), peeling may occur depending on adhesion between the materials.

### CITATION LIST

### PATENT LITERATURE

Patent Literature 1: JP4926523B
Patent Literature 2: JP5803919B
Patent Literature 3: JP2011-530823A
Patent Literature 4: JP2021-071685A

### SUMMARY OF INVENTION

### TECHNICAL PROBLEM

An object of the present invention is to to improve resistance to hydrogen radicals and protect a capping layer that may be damaged by forming a protective film during production of a reflective photomask. A further object is to form the capping layer and a protective layer with the same material to reduce deterioration of transferability due to a phase difference of a reflective portion, and to solve a problem of adhesion due to deposition of different materials. In other words, an object of the present invention is to provide a reflective photomask that can reduce deterioration in transferability due to a phase difference in a reflective portion and improve adhesion (interlayer adhesion) between a capping layer and a protective layer while having excellent hydrogen radical resistance.

### SOLUTION TO PROBLEM

A reflective photomask according to an aspect of the present technique includes: a substrate; a reflective layer formed on the substrate and including a multilayer film configured to reflect EUV light; a capping layer formed on the reflective layer; an absorber formed on a part of the capping layer and configured to absorb the EUV light; and a protective layer formed on the capping layer, on the absorber, and on a sidewall of the absorber, in which an extinction coefficient k of the absorber with respect to the EUV light is 0.04 or more, the capping layer and the protective layer are formed of a same material, a reflectivity with respect to the EUV light of a reflective portion, which is a region on the capping layer where the absorber is not formed, is 50% or more, a total film thickness of the capping layer and the protective layer is 3 nm or more, and the capping layer and the protective layer have resistance to hydrogen radicals.

### ADVANTAGEOUS EFFECTS OF INVENTION

According to the aspect of the present invention, it is possible to provide a reflective mask having high hydrogen radical resistance and a sufficient EUV reflectivity in a reflective portion. More specifically, according to the aspect of the present invention, it is possible to provide a reflective photomask that can reduce deterioration in transferability due to a phase difference in a reflective portion and improve adhesion (interlayer adhesion) between a capping layer and a protective layer while having excellent hydrogen radical resistance.

### BRIEF DESCRIPTION OF DRAWINGS

FIG. 1 is a schematic cross-sectional view showing a structure of a reflective mask according to an embodiment of the present invention.
FIG. 2 is a graph indicating optical constants of metals at an EUV light wavelength.
FIG. 3 is a conceptual diagram showing a method for evaluating hydrogen radical resistance according to the present embodiment.
FIG. 4 is a graph showing an EUV reflectivity in a reflective portion of the reflective mask according to the embodiment of the present invention.
FIG. 5 is a schematic cross-sectional view showing a production step of a reflective mask according to an example of the present invention.
FIG. 6 is a schematic cross-sectional view showing a production step of a reflective mask according to an example of the present invention.
FIG. 7 is a schematic cross-sectional view showing a production step of a reflective mask according to an example of the present invention.
FIG. 8 is a schematic cross-sectional view showing a structure of a reflective mask according to an example of the present invention.

### DESCRIPTION OF EMBODIMENTS

Hereinafter, a structure of a reflective mask according to an embodiment of the present invention will be described with reference to the drawings.

### (Overall Structure)

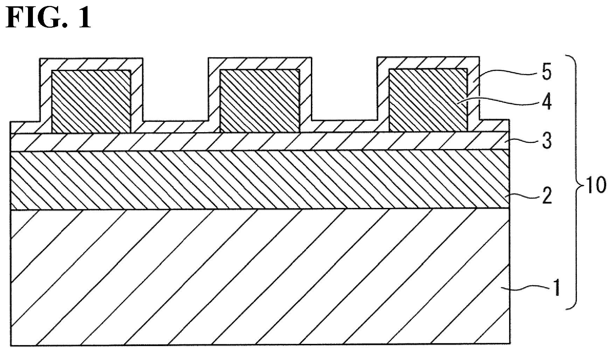

FIG. 1 is a schematic cross-sectional view showing a configuration of a reflective photomask with a covering film (hereinafter, also simply referred to as the "reflective mask") 10.

The reflective mask 10 is a reflective photomask for pattern transfer using extreme ultraviolet light as a light source, and includes a substrate 1, a reflective layer 2 formed on the substrate 1 and including a multilayer film configured to reflect EUV light, a capping layer 3 formed on the reflective layer 2, an absorber 4 formed on a part of the capping layer 3 and absorbing EUV light, and a protective layer 5 formed on the capping layer 3, on the absorber 4, and on a sidewall of the absorber 4. An extinction coefficient k of the absorber 4 with respect to EUV light is 0.04 or more. The capping layer 3 and the protective layer 5 are formed of the same material, have a total film thickness of 3 nm or more, and have resistance to hydrogen radicals. Further, a reflectivity with respect to EUV light of a reflective portion, which is a region where the absorber 4 is not formed on the capping layer 3, is 50% or more.

Hereinafter, each layer constituting the reflective mask 10 will be described in detail.

### (Substrate)

The substrate 1 according to the present embodiment is, for example, a low thermal expansion substrate. Specifically, a flat Si substrate, a synthetic quartz substrate, or the like can be used as the substrate. As the substrate, low thermal expansion glass to which titanium is added can be used. In this way, the substrate is not limited to these materials as long as the material has a small coefficient of thermal expansion.

### (Multilayer Reflective Film)

The multilayer reflective film (reflective layer) 2 according to the present embodiment is a film (layer) formed on the substrate 1. The multilayer reflective film 2 is a film for reflecting EUV light (extreme ultraviolet light) that is exposure light, and is, for example, a multilayer reflective film formed by combining materials having significantly different refractive indices with respect to EUV light. The multilayer reflective film 2 is preferably, for example, a deposited film in which a layer containing Mo (molybdenum) and a layer containing Si (silicon) are deposited, or a film formed by repeatedly depositing a deposited film in which a layer containing Mo (molybdenum) and a layer containing Be (beryllium) are deposited for about 40 periods.

### (Capping Layer)

The capping layer 3 according to the present embodiment is a layer formed on the multilayer reflective film 2. The capping layer 3 is formed of a material having resistance to dry etching performed when the absorber 4 is formed. That is, the capping layer 3 functions as an etching stopper that prevents damage to the multilayer reflective film 2 when an absorption layer is etched to form a transfer pattern (absorber 4).

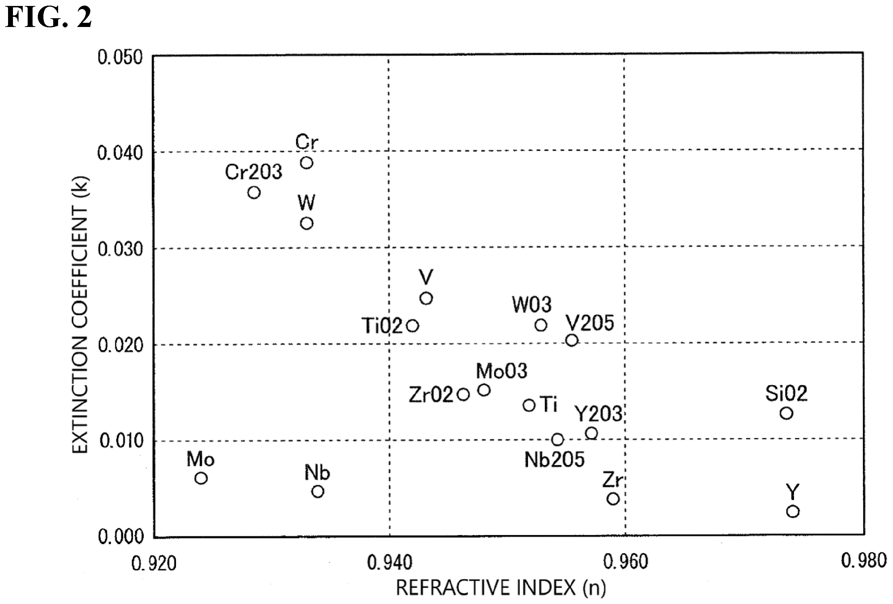

The capping layer 3 is preferably a layer formed of the same material as the protective layer 5 to be described later, and is preferably a layer formed of a compound material having hydrogen radical resistance and an extinction coefficient k of 0.035 or less. Therefore, as shown in FIG. 2, the capping layer 3 is preferably a layer containing at least one selected from ruthenium (Ru), yttrium (Y), niobium (Nb), titanium (Ti), zirconium (Zr), molybdenum (Mo), vanadium (V), tungsten (W), silicon oxide (SiO₂), yttrium oxide (Y₂O₃), niobium oxide (Nb₂O₅), titanium oxide (TiO₂), zirconium oxide (ZrO₂), molybdenum oxide (MoO₃), vanadium oxide (V₂O₅), silicon oxide (SiO), and tungsten oxide (WO₃), and more preferably a layer formed of a metal film or metal oxide film containing at least one of ruthenium (Ru), silicon (Si), yttrium (Y), niobium (Nb), titanium (Ti), zirconium (Zr), molybdenum (Mo), vanadium (V), and tungsten (W).

The capping layer 3 preferably contains 50% or more of the above-described elements in terms of an atomic ratio. If the capping layer 3 contains 50% or more of the above-described elements in terms of an atomic ratio, the extinction coefficient k of the capping layer 3 can be easily set to 0.035 or less with respect to EUV.

The extinction coefficient k of the capping layer 3 may be adjusted by appropriately adjusting a content ratio of the material forming the capping layer 3.

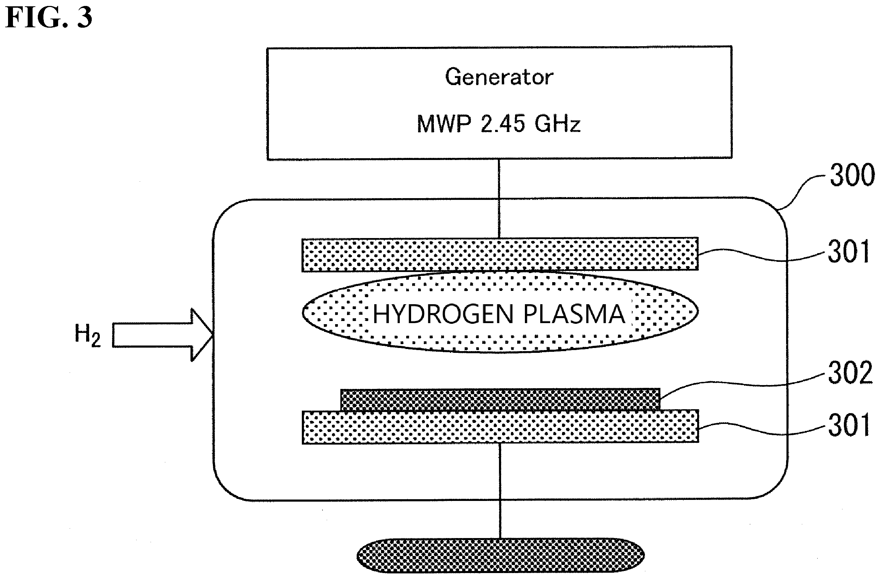

In the present embodiment, the term "material having hydrogen radical resistance" means, for example, a compound material having a film loss of 1 nm or less in a hydrogen radical environment excited under conditions that an apparatus shown in FIG. 3 is used, a hydrogen flow rate is 100 sscm, 2.45 GHz microwave plasma (MWP) is applied, and a distance between electrodes 301 is set to 18 mm. The term "film (layer) having resistance to hydrogen radicals" means a film (layer) having a film loss of 1 nm or less in the hydrogen radical environment described above.

The extinction coefficient k of the capping layer 3 with respect to EUV light is preferably 0.035 or less. If the extinction coefficient k of the capping layer 3 with respect to EUV light is 0.035 or less, sufficient transparency can be obtained, and deterioration in transferability due to a phase difference in the reflective portion can be reduced.

In addition, in order to protect the multilayer reflective film 2, a film thickness of the capping layer 3 is preferably 1.0 nm or more, and more preferably 1.5 nm or more in a remaining film state after the absorber 4 is formed.

The film thickness of the capping layer 3 before pattern processing, that is, the film thickness of the capping layer 3 in a photomask blank is desirably 4.5 nm or less, more desirably 3.5 nm or less, in order to reduce a film thickness of the absorber 4. In addition, in order to reduce damage to the multilayer reflective film 2 due to the pattern processing, a remaining film of the capping layer 3 is more preferably 1.5 nm or more.

### (Absorber)

The absorber 4 according to the present embodiment is desirably formed of a material having high EUV absorption in order to reduce a shadowing effect, and is desirably formed of an elemental substance or compound containing at least one material having k = 0.040 or more. As the material forming the absorber 4, for example, a simple substance or a compound containing one or more selected from Te, Sb, Pt, I, Bi, Ir, Os, W, Re, Sn, In, Pd, Fe, Au, Hg, Ta, Ga, and Ni is desirable, and a non-metal material such as oxygen, nitrogen, or hydrogen may be contained.

The material forming the absorber 4 preferably contains 50% or more of the above-described metal elements in terms of an atomic ratio. If the absorber 4 contains 50% or more of the above-described metal elements in terms of an atomic ratio, the extinction coefficient k of the absorber 4 can be easily set to 0.04 or more with respect to EUV.

The extinction coefficient k of the absorber 4 may be adjusted by appropriately adjusting a content ratio of the material forming the absorber 4.

The film thickness of the absorber 4 may be in a range of 10 nm or more and 50 nm or less, more preferably in a range of 20 nm or more and 40 nm or less, and still more preferably in a range of 25 nm or more and 35 nm or less. If the film thickness of the absorber 4 is within the above numerical range, EUV light can be effectively absorbed and the absorber 4 can be thinner.

For a purpose of improving pattern resolution of the absorber 4, one or more layers of a hard mask (not shown) may be provided on the absorber 4. A material of the hard mask is desirably, for example, a material containing at least one element such as Cr, Si, or Ta.

### (Protective Layer)

The protective layer 5 is a layer formed of a material having resistance to hydrogen radicals, and is a film formed on the capping layer 3 and on a surface and a sidewall of the absorber 4. The protective layer 5 is a layer formed of the same material as the capping layer 3.

In the case of the reflective mask 10 according to the present embodiment, since the protective layer 5 is an outermost layer in the reflective mask 10, it is preferable that the protective layer 5 does not obstruct the optical paths of incident light and reflected light. In order to prevent deterioration in resolution due to the shadowing effect, the extinction coefficient k of the protective layer 5 that is the outermost layer is desirably 0.035 or less. In addition, a film thickness of the protective layer 5 is desirably 2.0 nm or more, and more desirably 2.5 nm or more in order to ensure uniform deposition on an exposed surface (surface) of the capping layer 3 and exposed surfaces (surface and sidewall) of the absorber 4 and ensure resistance to hydrogen radicals.

Therefore, a total film thickness of the capping layer 3 and the protective layer 5 is preferably 3.0 nm or more.

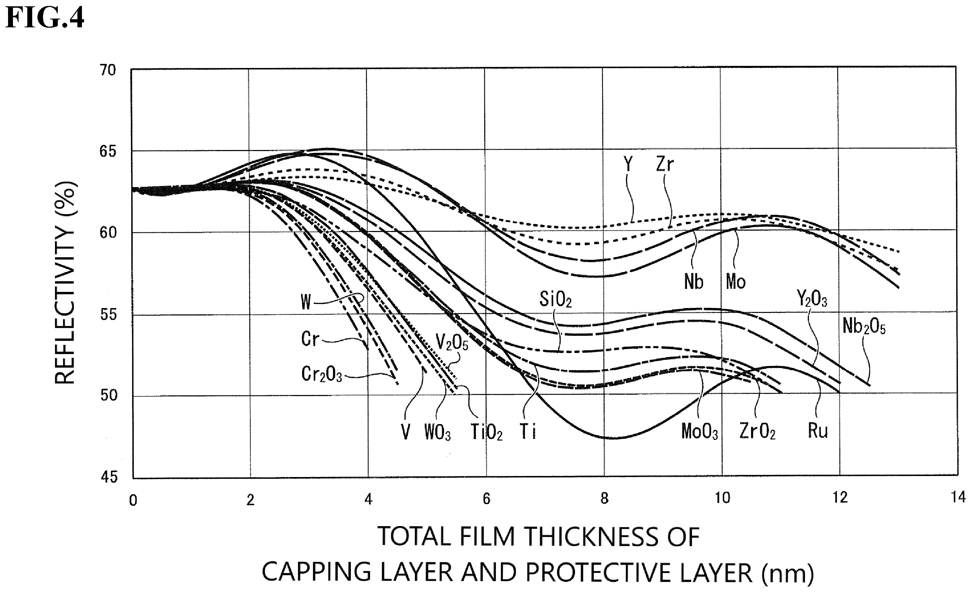

When the total film thickness of the capping layer 3 and the protective layer 5 is increased, reduction in the EUV light reflectivity of the reflective portion and an influence of the shadowing effect on the absorber 4 are increased, and thus the total film thickness is preferably 10 nm or less, and more preferably 8 nm or less. FIG. 4 shows a result that the EUV light reflectivity in the reflective portion decreases as the total film thickness of the capping layer 3 and the protective layer 5 increases.

In addition, in order to maintain a contrast that enables pattern transfer, it is preferable that an OD value of the absorber 4 and the protective layer 5 as a whole is 1 or more.

In this way, the material forming the protective layer 5 is preferably a compound material having hydrogen radical resistance and an extinction coefficient k of 0.035 or less. Therefore, as shown in FIG. 2, the protective layer 5 is preferably a layer containing at least one of ruthenium (Ru), yttrium (Y), niobium (Nb), titanium (Ti), zirconium (Zr), molybdenum (Mo), vanadium (V), tungsten (W), silicon oxide (SiO₂), yttrium oxide (Y₂O₃), niobium oxide (Nb₂O₅), titanium oxide (TiO₂), zirconium oxide (ZrO₂), molybdenum oxide (MoO₃), vanadium oxide (V₂O₅), silicon oxide (SiO), and tungsten oxide (WO₃), and more preferably a layer formed of a metal film or metal oxide film containing at least one of ruthenium (Ru), silicon (Si), yttrium (Y), niobium (Nb), titanium (Ti), zirconium (Zr), molybdenum (Mo), vanadium (V), and tungsten (W).

The protective layer 5 preferably contains 50% or more of the above-described elements in terms of an atomic ratio. If the protective layer 5 contains 50% or more of the above-described elements in terms of an atomic ratio, the extinction coefficient k of the protective layer 5 can be easily set to 0.035 or less with respect to EUV.

The extinction coefficient k of the protective layer 5 may be adjusted by appropriately adjusting a content ratio of the material forming the protective layer 5.

Although not shown in FIG. 1, in the reflective mask 10 according to the present embodiment, a backside conductive film can be formed on a surface of the substrate 1 opposite from a surface where the multilayer reflective film 2 is formed. The backside conductive film is a film for fixing the reflective mask 10 using a principle of an electrostatic chuck when the reflective mask 10 is set in an exposure apparatus.

### (Method for Forming Protective Layer)

When the reflective mask 10 according to the present embodiment is produced, the protective layer 5 may be formed by an atomic layer deposition method using a gas containing at least one of ruthenium (Ru), silicon (Si), yttrium (Y), niobium (Nb), titanium (Ti), zirconium (Zr), molybdenum (Mo), vanadium (V), and tungsten (W).

The atomic layer deposition method can form a thin film on an atomic-layer-by-atomic-layer basis. Therefore, the protective layer 5 formed by this method has high film thickness uniformity and high shape conformality.

A reflectivity of EUV light in the reflective portion, which is a region where the capping layer 3 and the protective layer 5 are deposited, is 50% or more. If the reflectivity of EUV light in the reflective portion is 50% or more, excellent transferability is obtained.

The protective layer 5 formed to cover the exposed surfaces of the capping layer 3 and the absorber 4 has an allowable film thickness that is limited in order to prevent deterioration in the transferability due to the protective layer 5 as described above, and the protective layer 5 to be formed is required to have a uniform film thickness. Therefore, by forming the protective layer 5 by the atomic layer deposition method enabling excellent film thickness uniformity and shape conformality, it is possible to produce the reflective mask 10 having high hydrogen radical resistance without deteriorating pattern transferability. Here, the term "uniform film thickness" means that a thickness of a thinnest portion is within a range of -2 nm and a thickness of a thickest portion is within a range of +2 nm with respect to an average thickness of the protective layer 5 formed on the capping layer 3 and on the surface and the sidewall of the absorber 4. That is, in the present embodiment, a layer thickness of the protective layer 5 formed on the surface of the absorber 4 falls within a range of ± 2 nm with respect to the average thickness. In addition, the layer thickness of the protective layer 5 formed on the sidewall of the absorber 4 falls within a range of ± 2 nm with respect to the average thickness. Further, the thickness of the protective layer 5 formed on the capping layer 3 is within a range of ± 2 nm with respect to the average thickness.

In this way, in the reflective mask 10 according to the present embodiment, the protective layer 5 having high hydrogen radical resistance is formed on the capping layer 3 and the surface and the sidewall of the absorber 4 using the atomic layer deposition method. The capping layer 3 is also formed of a material having high hydrogen radical resistance. Therefore, the reflective mask 10 can withstand long-term use.

Since the capping layer 3 and the protective layer 5 are uniformly formed of a material having a high EUV transmittance, deterioration in transferability due to formation of the capping layer 3 and the protective layer 5 can be prevented. Therefore, even when an absorption layer material having low hydrogen radical resistance is used, high pattern transfer accuracy can be obtained.

Since the protective layer 5 is formed of the same material as that of the capping layer 3, it is possible to reduce deterioration in transferability due to a phase difference in the reflective portion that is a region where the absorber 4 is not formed on the capping layer 3.

In addition, since the protective layer 5 is formed of the same material as the capping layer 3, adhesion (interlayer adhesion) between the capping layer 3 and the protective layer 5 can be improved.

### [Example 1]

Hereinafter, reflective masks according to examples of the present invention will be described with reference to the drawings and the tables.

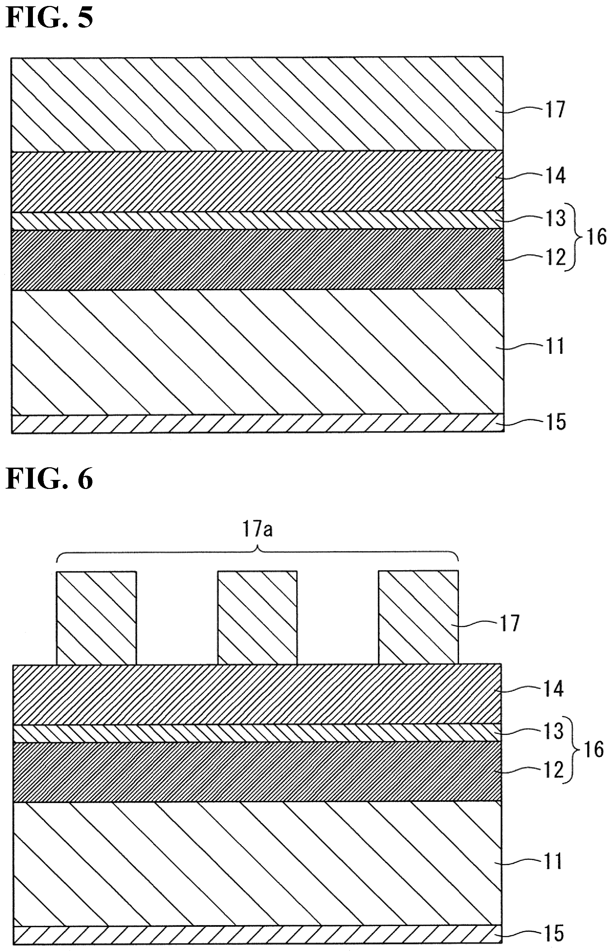

As shown in FIG. 5, a multilayer reflective film 12 formed by stacking 40 pairs of silicon (Si) and molybdenum (Mo) layers was formed on a synthetic quartz substrate 11 having low thermal expansion. A film thickness of the multilayer reflective film 12 was set to 280 nm.

Next, a capping layer 13 formed of ruthenium (Ru) as an intermediate film was deposited on the multilayer reflective film 12 such that a film thickness thereof was 2.5 nm. Accordingly, a reflective layer (reflective portion) 16 including the multilayer reflective film 12 and the capping layer 13 is formed on the substrate 11.

An absorber 14 formed of platinum (Pt) was deposited on the capping layer 13 such that a film thickness thereof was 26 nm. The extinction coefficient k of platinum (Pt) that is the material of the absorber 14 is 0.04 or more, which is higher than the extinction coefficient k of tantalum (Ta).

Next, on a side of the substrate 11 where the multilayer reflective film 12 was not formed, a backside conductive film 15 formed of chromium nitride (CrN) was deposited to a thickness of 100 nm.

A multi-target sputtering apparatus was used for the deposition of each film on the substrate 11. The film thickness of each film was controlled by a sputtering time.

Next, a resist film 17 was formed by depositing a positive chemically amplified resist (SEBP9012: produced by Shin-Etsu Chemical Co., Ltd.) on the absorber 14 to a film thickness of 120 nm by spin coating, followed by baking at 110°C for 10 minutes.

Next, a predetermined pattern was drawn on the positive chemically amplified resist by an electron beam lithography apparatus (JBX3030: produced by JEOL Ltd.).

Thereafter, the resist film 17 was subjected to a baking treatment at 110°C for 10 minutes, and then subjected to spray development (SFG3000: produced by Sigmameltec Ltd.). Accordingly, as shown in FIG. 6, a resist pattern 17a was formed.

Next, using the resist pattern as an etching mask, the absorber 14 was patterned by dry etching mainly using a chlorine-based gas to form an absorber pattern 14a.

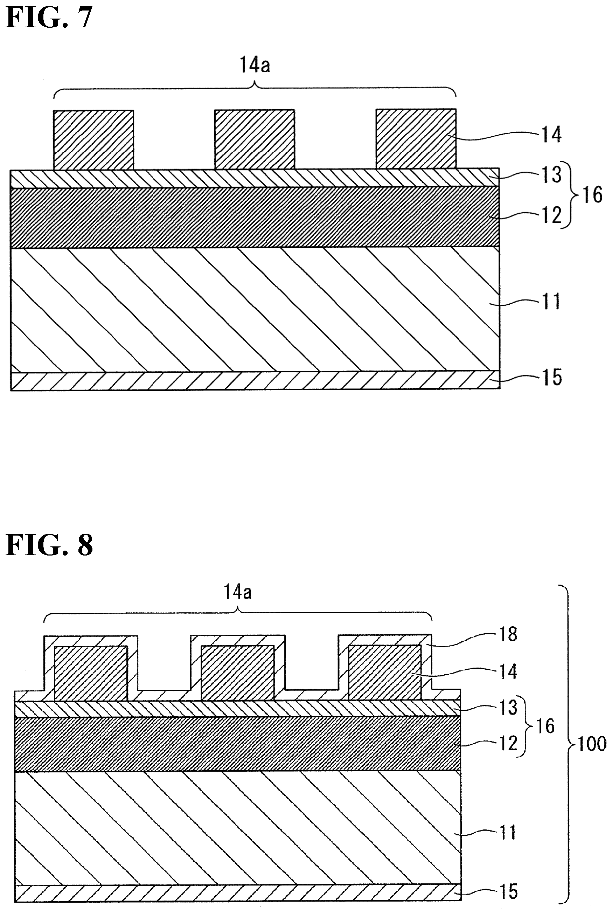

Next, the remaining resist pattern 17a was peeled off. In this way, as shown in FIG. 7, the absorber pattern 14a where a surface and a sidewall of the absorber 14 were exposed was formed.

In the present example, the absorber pattern 14a was a line-and-space (LS) pattern having a line width of 64 nm.

The capping layer 13 having a film thickness of 2.5 nm was reduced by 1.5 nm by patterning described above, and the film thickness of the capping layer 13 after patterning was 1 nm. The film thickness was measured using a scanning probe microscope.

Next, a protective layer 18 formed of ruthenium (Ru) was deposited on the exposed surface and the exposed sidewall of the absorber 14 and on a reflective layer 16 (capping layer 13) by an atomic layer deposition method using a gas containing ruthenium (Ru). At this time, a film thickness of the protective layer 18 was adjusted such that a total film thickness of the capping layer 13 and the protective layer 18 was 3 nm, that is, a film thickness of the protective layer 18 was 2 nm. The deposited protective layer 18 had a refractive index n of 0.886 and an extinction coefficient k of 0.017.

In this way, a reflective photomask (hereinafter, also simply referred to as "reflective mask") 100 according to Example 1 as shown in FIG. 8 was produced.

Next, for the absorber 14 of Example 1, a reflectivity Rm of a multilayer reflective film region and a reflectivity Ra of an absorption film region were measured by a reflectivity measurement apparatus using EUV light. As a result, as shown in Table 1, it was found that the EUV reflectivity in the multilayer reflective film region was 64.7%.

### [Example 2]

The absorber pattern 14a shown in FIG. 7 was formed in the same manner as in Example 1.

Next, the protective layer 18 formed of ruthenium (Ru) was deposited on the exposed surface and the exposed sidewall of the absorber 14 and on the reflective layer 16 (capping layer 13) by the atomic layer deposition method using the gas containing ruthenium (Ru). At this time, the film thickness of the protective layer 18 was adjusted such that the total film thickness of the capping layer 13 and the protective layer 18 was 10 nm. The deposited protective layer 18 had a refractive index n of 0.886 and an extinction coefficient k of 0.017.

In this way, the reflective photomask (hereinafter, also simply referred to as "reflective mask") 100 according to Example 2 as shown in FIG. 8 was produced.

Next, for the absorber 14 of Example 2, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 50.6%.

### [Example 3]

The absorber pattern 14a shown in FIG. 7 was formed in the same manner as in Example 1.

Next, the protective layer 18 formed of ruthenium (Ru) was deposited on the exposed surface and the exposed sidewall of the absorber 14 and on the reflective layer 16 (capping layer 13) by the atomic layer deposition method using the gas containing ruthenium (Ru). At this time, the film thickness of the protective layer 18 was adjusted such that the total film thickness of the capping layer 13 and the protective layer 18 was 12 nm. The deposited protective layer 18 had a refractive index n of 0.886 and an extinction coefficient k of 0.017.

In this way, the reflective photomask (hereinafter, also simply referred to as "reflective mask") 100 according to Example 3 as shown in FIG. 8 was produced.

Next, for the absorber 14 of Example 3, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 50.0%.

### [Example 4]

The absorber pattern 14a shown in FIG. 7 was formed in the same manner as in Example 1 except that the capping layer 13 was formed of yttrium (Y).

Next, the protective layer 18 formed of yttrium (Y) was deposited on the exposed surface and the exposed sidewall of the absorber 14 and on the reflective layer 16 (capping layer 13) by the atomic layer deposition method using a gas containing yttrium (Y). At this time, the film thickness of the protective layer 18 was adjusted such that the total film thickness of the capping layer 13 and the protective layer 18 was 4 nm. The deposited protective layer 18 had a refractive index n of 0.974 and an extinction coefficient k of 0.003.

In this way, the reflective photomask (hereinafter, also simply referred to as "reflective mask") 100 according to Example 4 as shown in FIG. 8 was produced.

Next, for the absorber 14 of Example 4, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 63.0%.

### [Example 5]

The absorber pattern 14a shown in FIG. 7 was formed in the same manner as in Example 1 except that the capping layer 13 was formed of yttrium (Y).

Next, the protective layer 18 formed of yttrium (Y) was deposited on the exposed surface and the exposed sidewall of the absorber 14 and on the reflective layer 16 (capping layer 13) by the atomic layer deposition method using the gas containing yttrium (Y). At this time, the film thickness of the protective layer 18 was adjusted such that the total film thickness of the capping layer 13 and the protective layer 18 was 10 nm. The deposited protective layer 18 had a refractive index n of 0.974 and an extinction coefficient k of 0.003.

In this way, the reflective photomask (hereinafter, also simply referred to as "reflective mask") 100 according to Example 5 as shown in FIG. 8 was produced.

Next, for the absorber 14 of Example 5, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 60.9%.

### [Example 6]

The absorber pattern 14a shown in FIG. 7 was formed in the same manner as in Example 1 except that the capping layer 13 was formed of yttrium (Y).

Next, the protective layer 18 formed of yttrium (Y) was deposited on the exposed surface and the exposed sidewall of the absorber 14 and on the reflective layer 16 (capping layer 13) by the atomic layer deposition method using the gas containing yttrium (Y). At this time, the film thickness of the protective layer 18 was adjusted such that the total film thickness of the capping layer 13 and the protective layer 18 was 13 nm. The deposited protective layer 18 had a refractive index n of 0.974 and an extinction coefficient k of 0.003.

In this way, the reflective photomask (hereinafter, also simply referred to as "reflective mask") 100 according to Example 6 as shown in FIG. 8 was produced.

Next, for the absorber 14 of Example 6, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 58.5%.

### [Example 7]

The absorber pattern 14a shown in FIG. 7 was formed in the same manner as in Example 1 except that the capping layer 13 was formed of niobium (Nb).

Next, the protective layer 18 formed of niobium (Nb) was deposited on the exposed surface and the exposed sidewall of the absorber 14 and on the reflective layer 16 (capping layer 13) by the atomic layer deposition method using a gas containing niobium (Nb). At this time, the film thickness of the protective layer 18 was adjusted such that the total film thickness of the capping layer 13 and the protective layer 18 was 4 nm. The deposited protective layer 18 had a refractive index n of 0.934 and an extinction coefficient k of 0.005.

In this way, the reflective photomask (hereinafter, also simply referred to as "reflective mask") 100 according to Example 7 as shown in FIG. 8 was produced.

Next, for the absorber 14 of Example 7, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 64.5%.

### [Example 8]

The absorber pattern 14a shown in FIG. 7 was formed in the same manner as in Example 1 except that the capping layer 13 was formed of niobium (Nb).

Next, the protective layer 18 formed of niobium (Nb) was deposited on the exposed surface and the exposed sidewall of the absorber 14 and on the reflective layer 16 (capping layer 13) by the atomic layer deposition method using the gas containing niobium (Nb). At this time, the film thickness of the protective layer 18 was adjusted such that the total film thickness of the capping layer 13 and the protective layer 18 was 12 nm. The deposited protective layer 18 had a refractive index n of 0.934 and an extinction coefficient k of 0.005.

In this way, the reflective photomask (hereinafter, also simply referred to as "reflective mask") 100 according to Example 8 as shown in FIG. 8 was produced.

Next, for the absorber 14 of Example 8, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 59.5%.

### [Example 9]

The absorber pattern 14a shown in FIG. 7 was formed in the same manner as in Example 1 except that the capping layer 13 was formed of niobium oxide (Nb₂O₅).

Next, the protective layer 18 formed of niobium oxide (Nb₂O₅) was deposited on the exposed surface and the exposed sidewall of the absorber 14 and on the reflective layer 16 (capping layer 13) by the atomic layer deposition method using a gas containing niobium (Nb) and oxygen (O). At this time, the film thickness of the protective layer 18 was adjusted such that the total film thickness of the capping layer 13 and the protective layer 18 was 3 nm. The deposited protective layer 18 had a refractive index n of 0.954 and an extinction coefficient k of 0.010.

In this way, the reflective photomask (hereinafter, also simply referred to as "reflective mask") 100 according to Example 9 as shown in FIG. 8 was produced.

Next, for the absorber 14 of Example 9, the reflectivity Rm of the multilayer reflective film region and the reflectivity Ra of the absorption film region were measured by the reflectivity measurement apparatus using EUV light. As a result, as shown in Table 1, it was found that the EUV reflectivity in the multilayer reflective film region was 64.7%.

### [Example 10]

The absorber pattern 14a shown in FIG. 7 was formed in the same manner as in Example 1 except that the capping layer 13 was formed of niobium oxide (Nb₂O₅).

Next, the protective layer 18 formed of niobium oxide (Nb₂O₅) was deposited on the exposed surface and the exposed sidewall of the absorber 14 and on the reflective layer 16 (capping layer 13) by the atomic layer deposition method using the gas containing niobium (Nb) and oxygen (O). At this time, the film thickness of the protective layer 18 was adjusted such that the total film thickness of the capping layer 13 and the protective layer 18 was 12 nm. The deposited protective layer 18 had a refractive index n of 0.954 and an extinction coefficient k of 0.010.

In this way, the reflective photomask (hereinafter, also simply referred to as "reflective mask") 100 according to Example 10 as shown in FIG. 8 was produced.

Next, for the absorber 14 of Example 10, the reflectivity Rm of the multilayer reflective film region (reflective portion) and the reflectivity Ra of the absorption film region (absorber) were measured by the reflectivity measurement apparatus using EUV light. As a result, as shown in Table 1, it was found that the EUV light reflectivity of the reflective portion, which is a region where the absorber 14 is not formed on the capping layer 13, was 51.7%.

### [Example 11]

The absorber pattern 14a shown in FIG. 7 was formed in the same manner as in Example 1 except that the capping layer 13 was formed of vanadium (V).

Next, the protective layer 18 formed of vanadium (V) was deposited on the exposed surface and the exposed sidewall of the absorber 14 and on the reflective layer 16 (capping layer 13) by the atomic layer deposition method using a gas containing vanadium (V). At this time, the film thickness of the protective layer 18 was adjusted such that the total film thickness of the capping layer 13 and the protective layer 18 was 4 nm. The deposited protective layer 18 had a refractive index n of 0.943 and an extinction coefficient k of 0.025.

In this way, the reflective photomask (hereinafter, also simply referred to as "reflective mask") 100 according to Example 11 as shown in FIG. 8 was produced.

Next, for the absorber 14 of Example 11, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 56.7%.

### [Example 12]

The absorber pattern 14a shown in FIG. 7 was formed in the same manner as in Example 1 except that the capping layer 13 was formed of chromium (Cr).

Next, the protective layer 18 formed of chromium (Cr) was deposited on the exposed surface and the exposed sidewall of the absorber 14 and on the reflective layer 16 (capping layer 13) by the atomic layer deposition method using a gas containing chromium (Cr). At this time, the film thickness of the protective layer 18 was adjusted such that the total film thickness of the capping layer 13 and the protective layer 18 was 3 nm. The deposited protective layer 18 had a refractive index n of 0.933 and an extinction coefficient k of 0.039.

In this way, the reflective photomask (hereinafter, also simply referred to as "reflective mask") 100 according to Example 12 as shown in FIG. 8 was produced.

Next, for the absorber 14 of Example 12, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 59.0%.

### [Example 13]

The absorber pattern 14a shown in FIG. 7 was formed in the same manner as in Example 1 except that the capping layer 13 was formed of chromium oxide (Cr₂O₃).

Next, the protective layer 18 formed of chromium oxide (Cr₂O₃) was deposited on the exposed surface and the exposed sidewall of the absorber 14 and on the reflective layer 16 (capping layer 13) by the atomic layer deposition method using a gas containing chromium (Cr) and oxygen (O). At this time, the film thickness of the protective layer 18 was adjusted such that the total film thickness of the capping layer 13 and the protective layer 18 was 4 nm. The deposited protective layer 18 had a refractive index n of 0.928 and an extinction coefficient k of 0.036.

In this way, the reflective photomask (hereinafter, also simply referred to as "reflective mask") 100 according to Example 13 as shown in FIG. 8 was produced.

Next, for the absorber 14 of Example 13, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 54.2%.

### [Example 14]

The absorber pattern 14a shown in FIG. 7 was formed in the same manner as in Example 1 except that the capping layer 13 was formed of silicon oxide (SiO₂).

Next, the protective layer 18 formed of silicon oxide (SiO₂) was deposited on the exposed surface and the exposed sidewall of the absorber 14 and on the reflective layer 16 (capping layer 13) by the atomic layer deposition method using a gas containing silicon (Si) and oxygen (O). At this time, the film thickness of the protective layer 18 was adjusted such that the total film thickness of the capping layer 13 and the protective layer 18 was 3 nm. The deposited protective layer 18 had a refractive index n of 0.974 and an extinction coefficient k of 0.013.

In this way, the reflective photomask (hereinafter, also simply referred to as "reflective mask") 100 according to Example 14 as shown in FIG. 8 was produced.

Next, for the absorber 14 of Example 14, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 61.5%.

### [Example 15]

The absorber pattern 14a shown in FIG. 7 was formed in the same manner as in Example 1 except that the capping layer 13 was formed of silicon oxide (SiO₂).

Next, the protective layer 18 formed of silicon oxide (SiO₂) was deposited on the exposed surface and the exposed sidewall of the absorber 14 and on the reflective layer 16 (capping layer 13) by the atomic layer deposition method using the gas containing silicon (Si) and oxygen (O). At this time, the film thickness of the protective layer 18 was adjusted such that the total film thickness of the capping layer 13 and the protective layer 18 was 10 nm. The deposited protective layer 18 had a refractive index n of 0.974 and an extinction coefficient k of 0.013.

In this way, the reflective photomask (hereinafter, also simply referred to as "reflective mask") 100 according to Example 15 as shown in FIG. 8 was produced.

Next, for the absorber 14 of Example 15, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 52.0%.

### [Comparative Example 1]

The absorber pattern 14a shown in FIG. 7 was formed in the same manner as in Example 1.

Next, the protective layer 18 formed of ruthenium (Ru) was deposited on the exposed surface and the exposed sidewall of the absorber 14 and on the reflective layer 16 (capping layer 13) by the atomic layer deposition method using the gas containing ruthenium (Ru). At this time, the film thickness of the protective layer 18 was adjusted such that the total film thickness of the capping layer 13 and the protective layer 18 was 2 nm. The deposited protective layer 18 had a refractive index n of 0.886 and an extinction coefficient k of 0.017.

In this way, the reflective photomask (hereinafter, also simply referred to as "reflective mask") 100 according to Comparative Example 1 as shown in FIG. 8 was produced.

Next, for the absorber 14 of Comparative Example 1, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 64.2%.

### [Comparative Example 2]

The absorber pattern 14a shown in FIG. 7 was formed in the same manner as in Example 1 except that the capping layer 13 was formed of niobium oxide (Nb₂O₅).

Next, the protective layer 18 formed of niobium oxide (Nb₂O₅) was deposited on the exposed surface and the exposed sidewall of the absorber 14 and on the reflective layer 16 (capping layer 13) by the atomic layer deposition method using the gas containing niobium (Nb) and oxygen (O). At this time, the film thickness of the protective layer 18 was adjusted such that the total film thickness of the capping layer 13 and the protective layer 18 was 2 nm. The deposited protective layer 18 had a refractive index n of 0.954 and an extinction coefficient k of 0.010.

In this way, the reflective photomask (hereinafter, also simply referred to as "reflective mask") 100 according to Comparative Example 2 as shown in FIG. 8 was produced.

Next, for the absorber 14 of Comparative Example 2, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 63.2%.

### [Comparative Example 3]

The absorber pattern 14a shown in FIG. 7 was formed in the same manner as in Example 1 except that the capping layer 13 was formed of vanadium (V).

Next, the protective layer 18 formed of vanadium (V) was deposited on the exposed surface and the exposed sidewall of the absorber 14 and on the reflective layer 16 (capping layer 13) by the atomic layer deposition method using the gas containing vanadium (V). At this time, the film thickness of the protective layer 18 was adjusted such that the total film thickness of the capping layer 13 and the protective layer 18 was 11 nm. The deposited protective layer 18 had a refractive index n of 0.943 and an extinction coefficient k of 0.025.

In this way, the reflective photomask (hereinafter, also simply referred to as "reflective mask") 100 according to Comparative Example 3 as shown in FIG. 8 was produced.

Next, for the absorber 14 of Comparative Example 3, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 42.0%.

### [Comparative Example 4]

The absorber pattern 14a shown in FIG. 7 was formed in the same manner as in Example 1 except that the capping layer 13 was formed of chromium oxide (Cr₂O₃).

Next, the protective layer 18 formed of chromium oxide (Cr₂O₃) was deposited on the exposed surface and the exposed sidewall of the absorber 14 and on the reflective layer 16 (capping layer 13) by the atomic layer deposition method using the gas containing chromium (Cr) and oxygen (O). At this time, the film thickness of the protective layer 18 was adjusted such that the total film thickness of the capping layer 13 and the protective layer 18 was 7 nm. The deposited protective layer 18 had a refractive index n of 0.928 and an extinction coefficient k of 0.036.

In this way, the reflective photomask (hereinafter, also simply referred to as "reflective mask") 100 according to Comparative Example 4 as shown in FIG. 8 was produced.

Next, for the absorber 14 of Comparative Example 4, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 37.3%.

### [Comparative Example 5]

The absorber pattern 14a shown in FIG. 7 was formed in the same manner as in Example 1 except that the capping layer 13 was formed of chromium (Cr).

Next, the protective layer 18 formed of chromium (Cr) was deposited on the exposed surface and the exposed sidewall of the absorber 14 and on the reflective layer 16 (capping layer 13) by the atomic layer deposition method using the gas containing chromium (Cr). At this time, the film thickness of the protective layer 18 was adjusted such that the total film thickness of the capping layer 13 and the protective layer 18 was 7 nm. The deposited protective layer 18 had a refractive index n of 0.933 and an extinction coefficient k of 0.039.

In this way, the reflective photomask (hereinafter, also simply referred to as "reflective mask") 100 according to Comparative Example 5 as shown in FIG. 8 was produced.

Next, for the absorber 14 of Comparative Example 5, the reflectivity Rm of the multilayer reflective film region and the reflectivity Ra of the absorption film region were measured by the reflectivity measurement apparatus using EUV light. As a result, as shown in Table 1, it was found that the EUV reflectivity of the reflective portion was 35.8%.

In Examples and Comparative Examples described above, the film thickness of each of the capping layer 13 and the protective layer 18 was measured using a transmission electron microscope.

### [EUV reflectivity]

In the present example, an EUV reflectivity of 50% or more was regarded as acceptable since sufficient transferability was obtained.

### [Hydrogen Radical Resistance]

Hydrogen was excited at a flow rate of 100 sscm using 2.45 GHz microwave plasma (MWP), and the prepared reflective photomask was placed on one of the electrodes with an inter-electrode distance of 18 mm. A film thickness change of the absorption film after a hydrogen radical treatment was checked using an atomic force microscope (AFM) and evaluated in the following three scores: ⊚, ○, and ×. Measurement was performed on an LS pattern having a line width of 200 nm.

In the present example, "⊚" and "○" were regarded as acceptable.

### <Evaluation Criteria>

⊚: a case where no film thickness change with respect to hydrogen radicals was observed
○: a case where a slight film thickness change with respect to hydrogen radicals was observed
×: a case where a film thickness change with respect to hydrogen radicals was observed

The above evaluation results are shown in Table 1.

**[Table 1]**

| Example | Material | n | k | Total film thickness (nm) | EUV reflectivity (%) | Hydrogen radical resistance |
|---|---|---|---|---|---|---|
| Example 1 | Ru | 0.886 | 0.017 | 3 | 64.7 | ○ |
| Example 2 | Ru | 0.886 | 0.017 | 10 | 50.6 | ○ |
| Example 3 | Ru | 0.886 | 0.017 | 12 | 50.0 | ○ |
| Example 4 | Y | 0.974 | 0.003 | 4 | 63.0 | ○ |
| Example 5 | Y | 0.974 | 0.003 | 10 | 60.9 | ○ |
| Example 6 | Y | 0.974 | 0.003 | 13 | 58.5 | ○ |
| Example 7 | Nb | 0.934 | 0.005 | 4 | 64.5 | ○ |
| Example 8 | Nb | 0.934 | 0.005 | 12 | 59.5 | ○ |
| Example 9 | Nb2O5 | 0.954 | 0.010 | 3 | 64.7 | ○ |
| Example 10 | Nb2O5 | 0.954 | 0.010 | 12 | 51.7 | ○ |
| Example 11 | V | 0.943 | 0.025 | 4 | 56.7 | ○ |
| Example 12 | Cr | 0.933 | 0.039 | 3 | 59.0 | ○ |
| Example 13 | Cr203 | 0.928 | 0.036 | 4 | 54.2 | ○ |
| Example 14 | SiO2 | 0.974 | 0.013 | 3 | 61.5 | ○ |
| Example 15 | SiO2 | 0.974 | 0.013 | 10 | 52.0 | ○ |
| Comparative Example 1 | Ru | 0.886 | 0.017 | 2 | 64.2 | × |
| Comparative Example 2 | Nb2O5 | 0.954 | 0.010 | 2 | 63.2 | × |
| Comparative Example 3 | V | 0.943 | 0.025 | 11 | 42.0 | ○ |
| Comparative Example 4 | Cr203 | 0.928 | 0.036 | 7 | 37.3 | ○ |
| Comparative Example 5 | Cr | 0.928 | 0.036 | 7 | 35.8 | ○ |

### [Adhesion (Interlayer Adhesion)]

In the present embodiment, the capping layer 13 and the protective layer 18 are formed of the same material. Therefore, the capping layer 13 and the protective layer 18 have adhesion sufficient to be regarded as one layer (single layer).

Therefore, the adhesion (interlayer adhesion) between the capping layer 13 and the protective layer 18 in the present Examples was regarded acceptable because it causes no practical problem in use.

As shown in Table 1, based on evaluation results of Examples 1 to 15 and Comparative Examples 1 to 5, according to the reflective photomask in which the extinction coefficient k of the absorber 14 with respect to EUV is 0.04 or more, the capping layer 13 and the protective layer 18 are formed of the same material, the reflectivity of EUV light in the reflective portion (multilayer reflective film region) that is the region where the absorber 14 is not formed on the capping layer 13 is 50% or more, further the total film thickness of the capping layer 13 and the protective layer 18 is 3 nm or more, and the capping layer 13 and the protective layer 18 have resistance to hydrogen radicals, it is possible to provide a reflective photomask that can reduce deterioration in transferability due to a phase difference in the reflective portion and improve adhesion (interlayer adhesion) between the capping layer 13 and the protective layer 18 while having excellent hydrogen radical resistance.

For example, the present invention may have the following configurations.
(1) A reflective photomask including:
   a substrate;
   a reflective layer formed on the substrate and including a multilayer film configured to reflect EUV light;
   a capping layer formed on the reflective layer;
   an absorber formed on a part of the capping layer and configured to absorb the EUV light; and
   a protective layer formed on the capping layer, on the absorber, and on a sidewall of the absorber, in which
   an extinction coefficient k of the absorber with respect to the EUV light is 0.04 or more,
   the capping layer and the protective layer are formed of the same material,
   a reflectivity with respect to the EUV light of a reflective portion, which is a region on the capping layer where the absorber is not formed, is 50% or more,
   a total film thickness of the capping layer and the protective layer is 3 nm or more, and
   the capping layer and the protective layer have resistance to hydrogen radicals.
(2) The reflective photomask according to (1), in which an extinction coefficient k of each of the capping layer and the protective layer with respect to the EUV light is 0.035 or less.
(3) The reflective photomask according to (1) or (2), in which the total film thickness of the capping layer and the protective layer is 10 nm or less.
(4) The reflective photomask according to any one of (1) to (3), in which the capping layer and the protective layer are each formed of a metal film or metal oxide film containing at least one of ruthenium (Ru), silicon (Si), yttrium (Y), niobium (Nb), titanium (Ti), zirconium (Zr), molybdenum (Mo), vanadium (V), and tungsten (W).

### INDUSTRIAL APPLICABILITY

The reflective mask according to the present invention can be suitably used for forming a fine pattern by EUV exposure in a production step of a semiconductor integrated circuit or the like.

### REFERENCE SIGNS LIST

- 1: substrate
- 2: multilayer reflective film (reflective layer)
- 3: capping layer
- 4: absorber
- 5: protective layer
- 10: reflective mask
- 11: substrate
- 12: multilayer reflective film (reflective layer)
- 13: capping layer
- 14: absorber
- 14a: absorber pattern
- 15: backside conductive film
- 16: reflective portion (reflective layer)
- 17: resist film
- 17a: resist pattern
- 18: protective layer
- 100: reflective mask
- 300: chamber
- 301: electrode
- 302: sample

## Claims

1. A reflective photomask comprising:
a substrate;
a reflective layer formed on the substrate and including a multilayer film configured to reflect EUV light;
a capping layer formed on the reflective layer;
an absorber formed on a part of the capping layer and configured to absorb the EUV light; and
a protective layer formed on the capping layer, on the absorber, and on a sidewall of the absorber, wherein
an extinction coefficient k of the absorber with respect to the EUV light is 0.04 or more,
the capping layer and the protective layer are formed of the same material,
a reflectivity with respect to the EUV light of a reflective portion, which is a region on the capping layer where the absorber is not formed, is 50% or more,
a total film thickness of the capping layer and the protective layer is 3 nm or more, and
the capping layer and the protective layer have resistance to hydrogen radicals.

2. The reflective photomask according to claim 1, wherein
an extinction coefficient k of each of the capping layer and the protective layer with respect to the EUV light is 0.035 or less.

3. The reflective photomask according to claim 1, wherein
the total film thickness of the capping layer and the protective layer is 10 nm or less.

4. The reflective photomask according to any one of claims 1 to 3, wherein
the capping layer and the protective layer are each formed of a metal film or metal oxide film containing at least one of ruthenium (Ru), silicon (Si), yttrium (Y), niobium (Nb), titanium (Ti), zirconium (Zr), molybdenum (Mo), vanadium (V), and tungsten (W).
